# EUROPÄISCHE PATENTANMELDUNG

(11) **EP 4 760 273 A1**
(43) Veröffentlichungstag der Anmeldung: **17.06.2026**
(21) Anmeldenummer: 25221019.0
(22) Anmeldetag: 05.12.2025
(51) Int. Cl.: G01R 19/00, G01R 15/18

(54) **SCHALTUNGSANORDNUNG ZUR STROMMESSUNG**

(30) Priorität: 13.12.2024 DE 102024211914
(71) Anmelder: Siemens Aktiengesellschaft, 80333 München (DE)
(72) Erfinder: Frankenberg, Robert, 1210 Wien (AT); Kussyk, Jaroslaw, 1210 Wien (AT)
(74) Vertreter: Siemens Patent Attorneys

(57) **Zusammenfassung**

Schaltungsanordnung zur Strommessung in einem, von einem Strom (I) durchflossenen Leiter (L), wobei ein Stromwandler (CT) dazu eingerichtet ist, von dem Strom (I) im Leiter (L) eine Eingangsspannung (U) zu erzeugen, welche dem Eingang (B1, B2) einer Dioden-Brückenschaltung (B) zugeführt wird, und ein erster Ausgang (B3) der Dioden-Brückenschaltung (B) an der Verbindung zweier gleichartiger erster Elektroden (E1, E2) zweier erster Dioden (D1, D2) der Dioden-Brückenschaltung (B) gelegen ist, wobei ein Messwiderstand (R) zur Strommessung zwischen den zwei gleichartigen zweiten Elektroden (E3, E4) der beiden zweiten Dioden (D3, D4) der Dioden-Brückenschaltung (B) eingefügt ist, ein zweiter Ausgang (B4) der Dioden-Brückenschaltung (B) an der Verbindung einer der zweiten Dioden (D3, D4) mit den zweiten Elektroden (E3, E4) und dem Messwiderstand (R) gelegen ist, und ein erweiterten Brücken-Knotenpunkt (B5) an der Verbindung der anderen der zweiten Dioden (D3, D4) mit den zweiten Elektroden (E3, E4) und dem Messwiderstand (R) gelegen ist, und jene zweite Diode (D4) der Dioden-Brückenschaltung (B), welche am zweiten Ausgang (B4) gelegen ist, durch die Source-Drain-Diode eines ersten selbstsperrenden Feldeffekt-Transistors (T1) gebildet ist, und jene zweite Diode (D3) der Dioden-Brückenschaltung (B), welche am erweiterten Brücken-Knotenpunkt (B5) gelegen ist, durch die Source-Drain-Diode eines zweiten selbstsperrenden Feldeffekt-Transistors (T2) gebildet ist, und eine Steuervorrichtung (CU) dazu eingerichtet ist, das Gate (G1) des ersten Feldeffekt-Transistors (T1) und das Gate (G2) des zweiten Feldeffekt-Transistors (T2) durch eine jeweils gleiche Steuerspannung anzusteuern, und eine Messvorrichtung (MU) dazu eingerichtet ist, am Messwiderstand (R) eine Messspannung zu messen, welche zum Strom (I) im Leiter (L) proportional ist.

## Beschreibung

Die Erfindung betrifft eine Schaltungsanordnung zur Strommessung in einem, von einem Strom durchflossenen Leiter, wobei ein Stromwandler dazu eingerichtet ist, von dem Strom im Leiter eine Eingangsspannung zu erzeugen, welche dem Eingang einer Dioden-Brückenschaltung zugeführt wird.

In elektrischer Energieverteilinfrastruktur, wie in intelligenten Gleich- und Wechselstrom-Verteilnetzen (sogenannte "Smart-Grids"), wird die Information über einen Netzzustand, beispielsweise Spannungsniveau, Strombelastung, Leistungsfluss, Lastverteilung, etc., meist durch viele verteilte Sensoreinheiten bestimmt.

Zur Überwachung und eventuell zur Steuerung der Netze werden dabei die Sensordaten übermittelt und zentral in einer Zentraleinheit ausgewertet.

Dabei ist es wichtig, dass die in Sensoreinheiten erfassten Strom-/Spannungsmessdaten eine Berechnung von Wirk- und Blindleistung ermöglichen.

In vielen Anwendungen der Sensoreinheiten für die Strommessung in elektrischen Wechselstrom-Verteilnetzen ist es von Vorteil, wenn die Sensoreinheit zur Eigenversorgung, Energie aus dem Stromleiter gewinnen in oder an dem diese installiert sind.

In der Regel werden dafür induktive Strommesswandler mit einem festen Kern aus einem magnetischen Material verwendet, welche den Stromleiter umschließen.

Die sekundäre Wicklung des Stromwandlers wird dabei an eine Gleichrichterschaltung, wie eine Dioden-Brückenschaltung angeschlossen, welche den gleichgerichteten Strom der Stromversorgung der Sensoreinheit bereitstellt.

Für eine Strommessung wird meistens parallel zur Sekundärwicklung des Stromwandlers über einen elektronischen Schalter periodisch ein Shunt-Widerstand beziehungsweise Messwiderstand zugeschaltet, an dem eine dem Primärstrom des Stromwandlers proportionale Spannung gemessen wird, wie in der Veröffentlichung EP4125180A1 angegeben.

Diese elektronischen Schalter und die sich danach befindliche Schaltung stehen vor der Herausforderung, dass das Stromesssignal, also die Spannung am Shunt-Widerstand, nicht direkt an die Masse der Stromversorgungsspannung bezogen werden kann, da sie defacto vor dem Gleichrichter abgegriffen wird.

Dafür bedarf es eines weiteren Differenzverstärkers, was eine höhere Systemkomplexität beziehungsweise zusätzliche Hardwarekosten mit sich bringt.

Um das letzte Problem zu lösen, sind Schaltungsanordnungen von Sensoreinheiten bekannt, welche einen Messwiderstand in Form eines Shunt-Widerstands nach der Gleichrichterschaltung zuschalten und damit auf eine direkte Erfassung vom Wechselspannungs-Messsignals verzichten, wobei nur der Effektivwert des Primärstroms gemessen werden kann.

Eine solche Schaltungsanordnung ist jedoch von großem Nachteil, wenn die Sensoreinheiten für eine (verteilte und) mit einer Referenzwechselspannung synchrone Messung von Wechselströmen zur Überwachung der Lastflussrichtung in elektrischen Energieverteilnetzen eingesetzt werden sollen.

Es ist daher Aufgabe der Erfindung eine Lösung für eine Strommessung mit reduziertem Aufwand bereitzustellen, welche keine zusätzliche, externe Stromversorgung benötigt.

Die erfindungsgemäße Aufgabe wird durch eine Schaltungsanordnung zur Strommessung in einem, von einem Strom durchflossenen Leiter gelöst, wobei ein Stromwandler dazu eingerichtet ist, von dem Strom im Leiter eine Eingangsspannung zu erzeugen, welche dem Eingang einer Dioden-Brückenschaltung zugeführt wird, und ein erster Ausgang der Dioden-Brückenschaltung an der Verbindung gleichartiger erster Elektroden der Dioden der Dioden-Brückenschaltung gelegen ist, wobei ein Messwiderstand zur Strommessung zwischen den zwei gleichartigen zweiten Elektroden der Dioden der Dioden-Brückenschaltung eingefügt ist, wobei sich die Art der zweiten Elektroden von der Art der ersten

Elektroden unterscheidet, ein zweiter Ausgang der Dioden-Brückenschaltung an der Verbindung einer der Dioden mit den zweiten Elektroden und dem Messwiderstand gelegen ist, und ein erweiterten Brücken-Knotenpunkt an der Verbindung der anderen der Dioden mit den zweiten Elektroden und dem Messwiderstand gelegen ist, und jene Diode der Dioden-Brückenschaltung, welche am zweiten Ausgang gelegen ist, durch die Source-Drain-Diode eines ersten selbstsperrenden Feldeffekt-Transistors gebildet ist, und jene Diode der Dioden-Brückenschaltung, welche am erweiterten Brücken-Knotenpunkt gelegen ist, durch die Source-Drain-Diode eines zweiten selbstsperrenden Feldeffekt-Transistors gebildet ist, und eine Steuervorrichtung dazu eingerichtet ist, das Gate des ersten Feldeffekt-Transistors und das Gate des zweiten Feldeffekt-Transistors durch eine jeweils gleiche Steuerspannung anzusteuern und so die Schaltungsanordnung zwischen einem Lademodus für einen Kondensator, welcher den ersten Ausgang mit dem erweiterten Brücken-Knotenpunkt verbindet, und in einen Messmodus umzuschalten, und eine Messvorrichtung dazu eingerichtet ist, im geschalteten Messmodus am Messwiderstand eine Messspannung zu messen, welche zum Strom im Leiter proportional ist.

Dadurch wird erreicht, dass sowohl die Funktion eines Gleichrichters als auch eines analogen Schalters angewandt wird, um einen Shunt-Widerstand ohne einen zusätzlichen Differenzverstärker für die Strommessung verwenden zu können, wie im Stand der Technik vorgesehen.

Damit ist durch die Modus-Umschaltung wahlweise eine Zuschaltung des Shunt-Widerstands für eine ungestörte Strommessung möglich.

Die Schaltungsanordnung ermöglicht eine kombinierte Energiegewinnung aus dem Leitungsstrom und eine Wechselstrommessung und reduziert den Realisierungsaufwand.

Dadurch kann eine Sensoreinheit für die Erfassung von Wechselstrom-Zeigern beziehungsweise Wechselspannungs-Zeigern realisiert werden, welche in einem verteilten Messystem von mehreren Sensoreinheiten zu einer zentralen Einheit übertragen werden sollen.

Dies ermöglicht eine ausreichend genaue Berechnung von Wirk- und Blindleistungsmittelwerten zur Lastflussüberwachung in elektrischen Wechselstromverteilnetzen.

Dadurch wird es außerdem ermöglicht, energiesparsame drahtlose Kommunikationstechnologien einzusetzen, was besonders bei Lösungen mit lokaler Energierückgewinnung aus den Strömen in einzelnen Phasenleitern eines Energieversorgungsnetzes von großem Vorteil ist.

Unter einer gleichen Steuerspannung für die Spannungen an den Gates der beiden Feldeffekttransistoren wird im vorliegenden Zusammenhang verstanden, dass ein Spannungs-Schwellwert erreicht oder überschritten wird, also sich der Feldeffekttransistor in einem aktiven oder geschalteten Zustand beziehungsweise einem niederohmigen Zustand in Sättigung befindet.

Mit anderen Worten entspricht das Anlegen derselben Gate-Spannung an beiden Transistoren Feldeffekttransistor dem Umschalten der Feldeffekttransistor vom Lademodus in den Messmodus, also einem logischen Umschalten der beiden Feldeffekttransistoren.

Der zweite Ausgang und der erweiterte Brücken-Knotenpunkt liegen klarerweise nicht am selben Verbindungspunkt.

Mit anderen Worten liegen der zweite Ausgang und der erweiterte Brücken-Knotenpunkt jeweils auf unterschiedlichen Seiten des Messwiderstands.

Die Dioden-Brückenschaltung ist somit zwischen den beiden Eingängen und den beiden Ausgängen durch eine Brückenschaltung mit Dioden und Dioden von Feldeffekttransistoren gebildet, wobei die Dioden der Feldeffekttransistoren durch entsprechende Steuerspannungen schaltbar sind.

In einer Weiterbildung der Erfindung ist es vorgesehen, dass der erste Eingang der Dioden-Brückenschaltung über eine weitere Diode mit dem erweiterten Brücken-Knotenpunkt verbunden ist, und die Art der Elektrode der weiteren Diode der Art der Elektroden der Dioden am erweiterten Brücken-Knotenpunkt entspricht.

In einer Weiterbildung der Erfindung ist es vorgesehen, dass die Messvorrichtung ferner dazu eingerichtet ist, zwischen dem Lademodus und dem Messmodus periodisch umzuschalten.

Dadurch kann das Aufladen des Kondensators vorwiegend über die weitere Diode der Dioden-Brücken-Schaltung erfolgen.

Damit wird ein schnelleres Aufladen vom Kondensator erzielt, beziehungsweise die notwendige Dauer des Lademodus verkürzt.

Zusätzlich kann der Messwiderstand vor hohen transienten Pulsströmen durch die weitere Diode geschützt werden.

Im Lademodus wird der Kondensator geladen.

Im Messmodus wird die Spannung am Messwiderstand von der Messvorrichtung ausgewertet.

Dadurch kann der Stromfluss im Leiter des Energieversorgungsnetzes periodisch überwacht werden.

Es ist klar, dass die Erfindung für alle Leiter eines Energieversorgungsnetzes separat angewandt werden kann.

In den nachfolgenden Figuren wird die Erfindung anhand eines Ausführungsbeispiels näher beschrieben. In den Figuren zeigt
- Fig. 1: einen Strom-Sensor nach dem Stand der Technik,
- Fig. 2 - 5: verschiedene Ausführungsbeispiele der Erfindung.

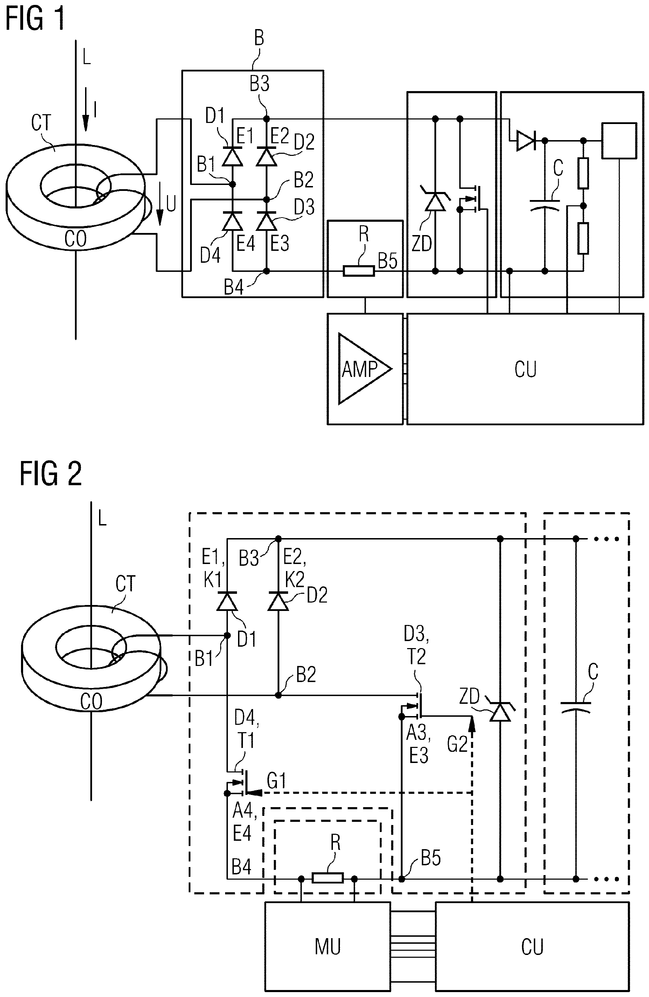

**Fig. 1** zeigt einen Strom-Sensor nach dem Stand der Technik, wobei in der Schaltungsanordnung ein stromführender Netzleiter L von einem Kern CO des induktiven Stromwandlers CT umschlossen ist.

Die sekundäre Wicklung des Stromwandlers CT ist an den Wechselspannungseingang des Gleichrichters in Form einer Dioden-Brückenschaltung B mit Brücken-Knotenpunkten B1-B4 und einem Messwiderstand R an einem erweiterten Brücken-Knotenpunkt B5 angeschlossen.

Die Dioden-Brückenschaltung B umfasst Dioden D1, D2, D3 und D4, welche auch in den nachfolgenden Figuren als Referenz dienen sollen.

Eine Zenerdiode ZD dient als Schutzelement für die Schaltung und ein Kondensator C dient zur Glättung nach dem Gleichrichter B.

Mit der Schaltungsanordnung kann dementsprechend eine Strommessung mithilfe des Messwiderstands R, einem Verstärker AMP und einer Steuerschaltung CU in einem, von einem Strom I durchflossenen Leiter L erfolgen.

Ein Stromwandler CT ist dazu eingerichtet, von dem Strom I im Leiter L eine Eingangsspannung U zu erzeugen, welche dem Eingang B1, B2 einer Dioden-Brückenschaltung B zugeführt wird, und ein erster Ausgang B3 der Dioden-Brückenschaltung B an der Verbindung gleichartiger erster Elektroden E1, E2 der Dioden D1, D2 der Dioden-Brückenschaltung B gelegen ist.

Die ersten Elektroden E1, E2 der Dioden D1, D2 sind deren Kathoden K1, K2.

In **Fig. 2** ist ein erstes Ausführungsbeispiel der erfindungsgemäßen Schaltungsanordnung mit einer Dioden-Brückenschaltung dargestellt, welche auf dem zuvor ausgeführten Stand der Technik aufbaut.

Die ersten Elektroden E1, E2 in Form von jeweiligen Kathoden K1, K2 von Dioden D1, D2 liegen am ersten Ausgang B3 der Dioden-Brückenschaltung B.

In der Schaltungsanordnung ist ein stromführender Netzleiter L von einem Kern CO des induktiven Stromwandlers CT umschlossen.

Die sekundäre Wicklung des Stromwandlers CT ist an den Wechselspannungseingang mit den Eingängen B1 und B2 des Gleichrichters in Form einer Dioden-Brückenschaltung B angeschlossen.

Die Dioden-Brückenschaltung B umfasst Dioden D1, D2, und einen ersten n-Kanal-Feldeffekttransistor T1 und einen zweiten n-Kanal-Feldeffekttransistor T1, welche jeweils im gesperrten Zustand die Funktion einer Diode erfüllen.

Die Dioden-Brückenschaltung B enthält außerdem einen Messwiderstand R zwischen den beiden Elektroden E3, E4, welcher ausreichend klein dimensioniert ist, um die Gleichrichterfunktionalität der Brückenschaltung B, beziehungsweise das Aufladen des Kondensators C nicht wesentlich zu beeinflussen.

Die Gate-Anschlüsse des ersten und zweiten n-Kanal-Feldeffekttransistors T1, T2 bilden Schaltungs-Knotenpunkte G1, G2, welche beispielsweise gemeinsam angesteuert werden können.

Der erste und zweite Feldeffekttransistor T1, T2 sind jeweils ein n-Kanal-FET, welche sich im gesperrten Zustand wie eine Diode verhalten.

Die Sensoreinheit mit einem Messwiderstand R kann über den Gleichrichter B mit Energie versorgt und der Kondensator C aufgeladen werden.

Sobald der Kondensator C genug Ladung gespeichert hat, wird die Schaltung von einem Ladezustand in einen Messzustand umgeschaltet.

Dafür wird an beiden Gate-Anschlüssen G1, G2 der FETs T1 und T2 die gleiche Spannung gegenüber Masse, dem erweiterten Brücken-Knotenpunkt B5, angelegt.

Dadurch werden die beiden FETs T1, T2 zwischen deren Source- und Drain-Anschlüssen niederohmig und verbinden den Shunt-Widerstand beziehungsweise Messwiderstand R mit den beiden Anschlüssen der Sekundärwicklung des Stromwandlers CT, also den Eingängen B1, B2.

Die Dioden D1 und D2 bleiben gesperrt und entladen dadurch den Kondensator C1 nicht, weil sie in dem Zustand durch die Spannung am aufgeladenen Kondensator C1 gegenüber der Masse B5 vorgespannt und außerdem zwischen den Schaltungsknoten B1 und B2 in entgegengesetzte Richtung miteinander verschalten sind.

Die zweiten Elektroden E3, E4 der Dioden D3, D4, gebildet durch die Transistoren T1, T2, sind deren Anoden A3, A4 und liegen am zweiten Ausgang B4.

Eine Diode D4 der Dioden-Brückenschaltung B, welche am zweiten Ausgang B4 gelegen ist, ist durch die Source-Drain- Diode eines ersten selbstsperrenden Feldeffekt-Transistors T1 gebildet.

Eine Steuervorrichtung CU ist dazu eingerichtet, das Gate des ersten Feldeffekt-Transistors T1 und das Gate des zweiten Feldeffekt-Transistors T2 durch eine gleiche Steuerspannung an den Knotenpunkten G1 und G2 anzusteuern und so die Schaltungsanordnung zwischen einem Lademodus für den Kondensator C, welcher den ersten Ausgang B3 mit dem Messwiderstand R am erweiterten Brücken-Knotenpunkt B5 verbindet, und einem Messmodus umzuschalten.

Somit liegt eine Serienschaltung von Messwiderstand R und Kondensator C zwischen dem ersten Ausgang B3 und dem zweiten Ausgang B4 vor.

Parallel zum Kondensator C kann eine Zenerdiode ZD zum Schutz der Schaltung angeordnet sein.

Die Knotenpunkte G1, G2 sind nur "logische" Darstellung, denn die Steuerspannungen können beispielsweise durch jeweilige Spannungsteiler bereitgestellt werden, daher die strichlierte Darstellung.

Eine Messvorrichtung MU ist dazu eingerichtet, im geschalteten Messmodus am Messwiderstand R, zwischen dem Knotenpunkt B4 und dem erweiterten Brücken-Knotenpunkt B5 eine Messspannung zu messen, welche zum Strom I im Leiter L proportional ist.

Die Messvorrichtung MU ist ferner dazu eingerichtet, zwischen dem Lademodus und dem Messmodus periodisch umzuschalten.

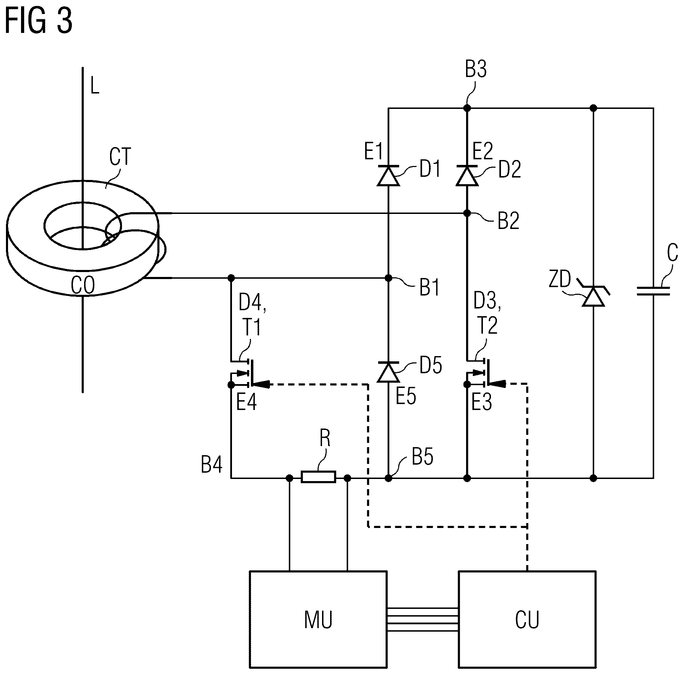

In **Fig. 3** ist ein zweites Ausführungsbeispiel der erfindungsgemäßen Schaltungsanordnung dargestellt.

Es gelten hier auch die Ausführungen der vorhergehenden Figur.

Zusätzlich zur vorhergehenden Figur ist eine weitere Diode D5 zwischen dem ersten Eingang B1 und dem erweiterten Brücken-Knotenpunkt B5 der Dioden-Brückenschaltung B eingefügt, wobei die Art der Elektrode der Diode D4, welche durch den Transistor T1 gebildet ist, und der weiteren Diode D5 am Verbindungspunkt dieselben sind.

Die Elektrode E5 der weiteren Diode D5 am erweiterten Brücken-Knotenpunkt B5 ist in diesem Ausführungsbeispiel eine Anode.

Die Summe aus dem Messwiderstand R und dem Source-Drain-Widerstand des ersten selbstsperrenden Feldeffekt-Transistors T1 ist derart bemessen, sodass die Messpannung unter der Schleusenspannung der weiteren Diode D5 der Dioden-Brückenschaltung B liegt, welche mit dem Source-Anschluss des zweiten selbstsperrenden Feldeffekt-Transistors T2 verbunden ist.

Dementsprechend kann der Messwiderstand R dimensioniert werden.

Das Aufladen des Kondensators C erfolgt vorwiegend über die Dioden D1-D3 und die weitere Diode D5 der Dioden-Brücken-Schaltung B.

Zum Teil erfolgt das Aufladen aber auch über die Diode D4 und den Messwiderstand R, die parallel zur weiteren Diode D5 geschaltet sind.

Damit wird ein schnelleres Aufladen vom Kondensator C erzielt, beziehungsweise die notwendige Dauer des Lademodus verkürzt.

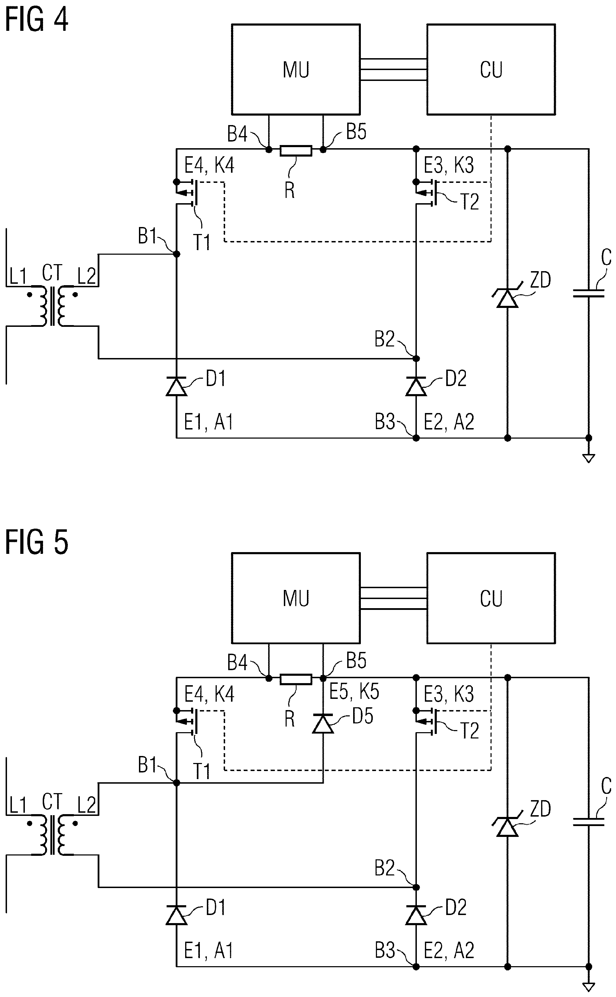

In **Fig. 4** ist ein drittes Ausführungsbeispiel der erfindungsgemäßen Schaltungsanordnung dargestellt.

Dabei sind der erste und der zweite selbstsperrende Feldeffekt-Transistor T1, T2 jeweils ein p-Kanal Transistor.

Die Ausführung ist der Schaltung nach Fig. 2 mit dem n-Kanal-Transistoren T1, T2 funktionell äquivalent, jedoch kann beispielsweise die Polarität des Stromwandlers CT und die Ansteuerung der Transistoren T1, T2 entsprechend berücksichtigt werden.

Die Dioden D1, D2 sind über deren Anoden A1, A2, welche hier den Elektroden E1, E2 entsprechen, zusammengeführt.

Die Dioden D3, D4, gebildet durch die Transistoren T1, T2, sind über deren Kathoden K1, K2, welche hier den Elektroden E3, E4 entsprechen, zusammengeführt.

Der Stromwandler CT kann Wicklungen L1, L2 umfassen, wobei die Wicklung L1 durch die Leitung L, die vom Kern CO gemäß den vorhergehenden Figuren umschlossen ist, gebildet sein kann.

Auch für die Ausführungsbeispiele der Figuren 2 und 3 kann es vorgesehen sein, dass der Stromwandler mehrere Windungen auf beiden Seiten aufweist.

In **Fig. 5** ist ein viertes Ausführungsbeispiel der erfindungsgemäßen Schaltungsanordnung dargestellt.

Dabei sind der erste und der zweite selbstsperrende Feldeffekt-Transistor T1, T2 jeweils ein p-Kanal Transistor.

Die Ausführung ist der Schaltung nach Fig. 3 mit dem n-Kanal-Transistoren T1, T2 funktionell äquivalent, jedoch kann beispielsweise die Polarität des Stromwandlers CT und die Ansteuerung der Transistoren T1, T2 entsprechend berücksichtigt werden.

Die Dioden D1, D2 sind über deren Anoden A1, A2, welche hier den Elektroden E1, E2 entsprechen, zusammengeführt.

Die Dioden D3, D4, gebildet durch die Transistoren T1, T2, sind über deren Kathoden K1, K2, welche hier den Elektroden E3, E4 entsprechen, zusammengeführt.

Ferner ist der erste Eingang B1 der Dioden-Brückenschaltung B über eine weitere Diode D5 mit dem erweiterten Brücken-Knotenpunkt B5 verbunden.

Die Kathode K5 der weiteren Diode D5 ist mit der Kathode K3 der Diode verbunden, welche durch den zweiten Transistor T2 gebildet ist.

*Unabhängig vom grammatikalischen Geschlecht eines bestimmten Begriffes sind Personen mit männlicher, weiblicher oder anderer Geschlechteridentität mit umfasst.*

### Bezugszeichenliste

- AMP: Verstärker
- A1-A4: Anode einer Diode
- B1-B5: Knotenpunkte
- B: Dioden-Brückenschaltung
- C: Kondensator
- CO: Kern
- CT: Stromwandler
- CU: Steuervorrichtung
- D1-D5: Diode
- E1-E5: Dioden-Elektroden, entweder Anode oder Kathode
- G1, G2: Gate eines Feldeffekt-Transistors
- I: Strom
- K1-K5: Kathode einer Diode
- L: Leitung
- L1, L2: Wicklungen eines Stromwandlers
- MU: Messvorrichtung
- R: Messwiederstand
- T1, T2: Transistor
- U: Eingangsspannung
- ZD: Zener-Diode

## Patentansprüche

1. Schaltungsanordnung zur Strommessung in einem, von einem Strom (I) durchflossenen Leiter (L), wobei ein Stromwandler (CT) dazu eingerichtet ist, von dem Strom (I) im Leiter (L) eine Eingangsspannung (U) zu erzeugen, welche dem Eingang (B1, B2) einer Dioden-Brückenschaltung (B) zugeführt wird, und ein erster Ausgang (B3) der Dioden-Brückenschaltung (B) an der Verbindung zweier gleichartiger erster Elektroden (E1, E2) der Dioden (D1, D2) der Dioden-Brückenschaltung (B) gelegen ist, und
**dadurch gekennzeichnet, dass**
ein Messwiderstand (R) zur Strommessung zwischen den zwei gleichartigen zweiten Elektroden (E3, E4) der Dioden (D3, D4) der Dioden-Brückenschaltung (B) eingefügt ist, wobei sich die Art der zweiten Elektroden (E3, E4) von der Art der ersten Elektroden (E1, E2) unterscheidet,
ein zweiter Ausgang (B4) der Dioden-Brückenschaltung (B) an der Verbindung einer der Dioden (D3, D4) mit den zweiten Elektroden (E3, E4) und dem Messwiderstand (R) gelegen ist, und
ein erweiterter Brücken-Knotenpunkt (B5) an der Verbindung der anderen der Dioden (D3, D4) mit den zweiten Elektroden (E3, E4) und dem Messwiderstand (R) gelegen ist, und jene Diode (D4) der Dioden-Brückenschaltung (B), welche am zweiten Ausgang (B4) gelegen ist, durch die Source-Drain-Diode eines ersten selbstsperrenden Feldeffekt-Transistors (T1) gebildet ist, und
jene Diode (D3) der Dioden-Brückenschaltung (B), welche am erweiterten Brücken-Knotenpunkt (B5) gelegen ist, durch die Source-Drain-Diode eines zweiten selbstsperrenden Feldeffekt-Transistors (T2) gebildet ist, und
eine Steuervorrichtung (CU) dazu eingerichtet ist, das Gate (G1) des ersten Feldeffekt-Transistors (T1) und das Gate (G2) des zweiten Feldeffekt-Transistors (T2) durch eine jeweils gleiche Steuerspannung anzusteuern und so die Schaltungsanordnung zwischen einem Lademodus für einen Kondensator (C), welcher den ersten Ausgang (B3) mit dem erweiterten Brücken-Knotenpunkt (B5) verbindet, und in einen Messmodus umzuschalten, und
eine Messvorrichtung (MU) dazu eingerichtet ist, im geschalteten Messmodus am Messwiderstand (R) eine Messspannung zu messen, welche zum Strom (I) im Leiter (L) proportional ist.

2. Schaltungsanordnung nach dem vorhergehenden Anspruch, wobei der erste Eingang (B1) der Dioden-Brückenschaltung (B) über eine weitere Diode (D5) mit dem erweiterten Brücken-Knotenpunkt (B5) verbunden ist, und die Art der Elektrode (E5) der weiteren Diode (D5) der Art der Elektroden (E3, E4) der Dioden (D3, D4) am erweiterten Brücken-Knotenpunkt (B5) entspricht.

3. Schaltungsanordnung nach einem der vorhergehenden Ansprüche, wobei die Messvorrichtung (MU) ferner dazu eingerichtet ist, zwischen dem Lademodus und dem Messmodus periodisch umzuschalten.
